# EUROPÄISCHE PATENTSCHRIFT

(11) **EP 2 079 166 B1**
(45) Veröffentlichungstag und Bekanntmachung des Hinweises auf die Patenterteilung: **18.11.2015**
(21) Anmeldenummer: 08021261.6
(22) Anmeldetag: 08.12.2008
(51) Int. Cl.: H03K 17/94, H03K 17/968, G01V 8/12

(54) **System mit einer Unterputzdose und einem Näherungssensor, insbesondere für Türanlagen**
System with a flush mounting support and a proximity sensor, in particular, for door assemblies
Dispositif avec un support encastré et un capteur de rapprochement, notamment pour installations de portes

(30) Priorität: 09.01.2008 DE 102008003564
(43) Veröffentlichungstag der Anmeldung: 15.07.2009
(73) Patentinhaber: DORMA Deutschland GmbH, 58256 Ennepetal (DE)
(72) Erfinder: Busch, Sven, 44227 Dortmund (DE)
(74) Vertreter: Balder IP Law, S.L.

(56) Entgegenhaltungen:
- DE-A1- 10 049 343
- DE-A1- 10 061 649
- DE-A1- 10 319 394
- DE-A1- 10 340 299
- DE-A1- 19 609 238
- DE-A1- 19 651 341
- DE-A1- 19 725 414

## Beschreibung

Die Erfindung betrifft einen Näherungssensor, insbesondere für Türanlagen.

Systeme, insbesondere zum Aktivieren von Türantrieben, zum Öffnen von Türen an sich sind bekannt. Um derartige Türanlagen berührungslos zu aktivieren, werden Sensoren verwendet, die als Bewegungsmelder oder Zustandmelder realisiert sind und damit in der Lage sind, das Vorhandensein von Objekten, wie beispielsweise Personen, in einem vorbestimmten Bereich vor der Tür und ggf. deren Bewegungsrichtung und Bewegungsgeschwindigkeit zu erfassen.

Üblicherweise werden als Näherungssensoren Radarsensoren verwendet, die eine so genannte "Strahlenkeule" emittieren und reflektierte Radarstrahlung detektieren können. D. h. die emittierte Radarstrahlung füllt einen bestimmten Raum vor dem Sensor aus, was eine Richtungserkennung in Bezug auf ein jeweiliges Objekt erschwert. Radarstrahlung steht zudem im Verdacht, krebsfördemd oder krebserregend zu sein,

Eine andere Art von Näherungssensoren sind passive Infrarot-Sensoren, bei denen von Objekten emittierte Wärme detektiert wird. Diese Sensoren sind allerdings nicht für Objekte geeignet, die selbst keine oder nur sehr geringe Wärmestrahlung abgeben, wie beispielsweise im Winter bei Personen mit Wärme isolierender Kleidung.

Daher wurden aktive Infrarot-Sensoren entwickelt, die selbst Infrarotstrahlung emittieren und Reflexionen dieser Strahlung detektieren. Die emittierte Strahlung hat die Form eines Strahlenbündels was eine Richtungserkennung in Bezug auf ein Objekt ermöglicht, das dieses Strahlenbündel reflektiert. Diese Sensoren sind so gestaltet, dass Objekte nur bis zu einem vorbestimmten Entfernungsmaß, beispielsweise 80 cm, detektiert werden.

Das Dokument DE 196 09 238 A1 offenbart ein Sensorgehäuse zur Aufnahme eines optoelektronischen Sensorelements mit einem Sender und einem Empfänger, wobei ein Gehäuseaufsatz mit einem Umlenkspiegel auf dem Gehäuse gelagert ist.

Aufgabe der Erfindung ist es, Näherungssensoren und damit ausgestatte Anlagen derart weiterzuentwickeln, dass das vorbeschriebene Risiko sicher vermieden wird, dass sie flexibel einsetzbar sind und /oder insbesondere hinsichtlich ästhetischer Aspekte verbessert sind.

Diese Aufgabe wird durch den Gegenstand des Anspruchs 1 gelöst. Vorteilhafte Weiterbildungen der Erfindung sind in den Unteransprüchen angegeben.

Ein erfindungsgemäßer Näherungssensor weist zumindest ein Sensorteil und eine Umlenkoptik auf. Das zumindest eine Sensorteil umfasst ein Sendeelement und ein Empfangselement. Das Sendeelement ist eingerichtet, eine gebündelte Strahlung in einen vorbestimmten Erfassungsbereich zu emittieren. Die gebündelte Strahlung ermöglicht eine präzise Überwachung eines eng umgrenzten Erfassungsbereichs. Das Empfangselement ist derart angeordnet, dass es von dem ersten Sendeelement emittierte und von einem in dem vorbestimmten Erfassungsbereich befindlichen Objekt reflektierte Strahlung empfängt. Der Näherungssensor ist gestaltet, in eine Unterputzdose eingesetzt zu werden. Dadurch ist es möglich, den Näherungssensor in einer Wand zu integrieren und trotzdem weiterhin wie gewohnt zu benutzen, was insbesondere ästhetisch Vorteile hat.

Das Empfangselement umfasst vorzugsweise mehrere lichtempfindliche Elemente, die gemäß einer vorbestimmten Matrix angeordnet sind. Die Matrix erlaubt dem Näherungssensor eine Entfemungsermittlung eines jeweiligen Objekts zum Sensor. Ferner umfasst das Empfangselement ein zwischen dem Objekt und den lichtempfindlichen Elementen derart angeordnetes Objektiv, dass von dem Objekt reflektierte Strahlung in Richtung der lichtempfindlichen Elemente gebündelt wird. Diese Bündelung ist vorteilhaft, da ein Objekt in der Regel Strahlen in verschiedene Richtungen reflektiert, was zu einer diffusen Reflexion führt. Die Bündelung der reflektierten Strahlen ermöglicht, dass die reflektierten Strahlen nur auf bestimmte lichtempfindliche Elemente und nicht auf andere oder alle auftreffen.

Der Näherungssensor weist eine Umlenkoptik auf, die im optischen Pfad der emittierten Strahlung zwischen dem Sendeteil und dem vorbestimmten Erfassungsbereich angeordnet und schwenkbar gelagert, in verschiedenen Stellungen arretierbar und in einer der verschiedenen Stellungen arretiert ist. Dies ermöglicht, das Sensorteil fest zu montieren und aufgrund der Umlenkoptik, die vorzugsweise mittels eines Spiegels gebildet ist, tief im Innenraum der Unterputzdose oder einer sonstigen Aufnahme des Näherungssensors zu versenken. Dies ermöglicht eine im Montagezustand besonders flache Bauweise in Bezug beispielsweise auf eine Wand.

Die verwendete Strahlung ist vorzugsweise Licht im Infrarot-Bereich. Als Sendeelement werden erfindungsgemäß vorzugsweise Laser, Leuchtdioden oder Laserdioden genutzt.

Der Näherungssensor weist vorzugsweise eine Abdeckung auf, die alle anderen Teile des Näherungssensors im Montagezustand nach außen abdeckt und zumindest einen Durchtrittsabschnitt aufweist, der für die Strahlung durchlässig ist. Die Abdeckung bietet Schutz vor mechanischen Einflüssen und vor Verschmutzung, insbesondere hinsichtlich der Optik des Näherungssensors.

Der Durchtrittsabschnitt ist vorzugsweise mittels einer Ausnehmung oder Durchgangsöffnung in der Abdeckung gebildet. Sie kann im Bereich des Durchtrittsabschnitts ein für die Strahlung durchlässiges Abdeckteil aufweisen. D. h. das Abdeckteil kann im Fall des Infrarotlichts für sichtbares Licht schwer oder gar nicht durchlässig, beispielsweise getönt, sein, sodass der Näherungssensor von außen nicht erkennbar ist.

Die Abdeckung ist vorzugsweise gestaltet, in eine Ausnehmung eines Abdeckrahmens eingesetzt zu werden, der auf einen Tragring aufgesetzt ist.

D. h. der erfindungsgemäße Näherungssensor ist in übliche Wandinstallationen von Lichtschaltern, Steckdosen und dergleichen integrierbar. Insbesondere ist es in Abdeckrahmen einsetzbar, die mehrere Unterputzelemente nach außen abdecken und damit jeweils auf mehrere Tragringe aufgesetzt sind. Die Ausnehmung ist vorzugsweise in einen Einsetzabschnitt und einen Aufsetzabschnitt aufgeteilt. Der Einsetzabschnitt ist in einem dem Tragring entfernten Bereich des Abdeckrahmens ausgebildet ist und weist im Querschnitt eine Innenkontur beispielsweise in Form eines Quadrats mit einer Kantenlänge von 55 mm auf. Der Näherungssensor weist vorzugsweise ferner eine Abdeckung auf, die im Querschnitt eine zur Innenkontur des Einsetzabschnitts komplementäre Außenkontur aufweist. D. h. es ist möglich, den Näherungssensor auch bei standardisierten 55 mm-Unterputzinstallationen zu verbauen.

Eine erfindungsgemäße Anlage, insbesondere Türanlage, weist einen Näherungssensor gemäß einer der vorbeschriebenen Ausgestaltungen und ferner eine mit einem Ausgang des Empfangselements des zumindest einen Sensorteils gekoppelte Auswerteschaltung auf. Die Auswerteschaltung ist ausgangsseitig mit zumindest einem Eingang einer Aktivierungsschaltung gekoppelt. Die Auswerteschaltung ist eingerichtet, lichtempfindliche Elemente zu ermitteln, an denen ein Maximum einer am Empfangselement ankommenden Strahlung vorliegt. Aufgrund der ermittelten Elemente kann die Auswerteschaltung auf Basis vorteilhafterweise des Triangulationsverfahrens eine Entfernung des die Strahlung reflektierenden Objekts ermitteln. Bei Unterschreiten und/oder Überschreiten einer vorbestimmten Entfernung gibt die Auswerteschaltung ein Aktivierungssignal an die Aktivierungsschaltung aus.

Zusätzlich umfasst die erfindungsgemäße Anlage vorzugsweise zumindest einen Türantrieb und/oder eine Tür-Feststellvorrichtung. Der Türantrieb und/oder die Tür-Feststellvorrichtung, ist/sind eingangsseitig mit einem Aktivierungsausgang der Aktivierungsschaltung gekoppelt. Im Falle eines Türantriebs kann dieser zum Öffnen einer angeschlossenen Tür angesteuert werden, sobald ein Objekt, wie eine Person, im Erfassungsbereich des Näherungssensors detektiert wird. Im Fall einer Tür-Feststellvorrichtung kann diese entriegelt werden, sobald sich kein Objekt mehr im Erfassungsbereich befindet. Dies ist bei Türanlagen sinnvoll, bei denen die Tür offen stehen bleiben soll, bis sich kein Objekt mehr im Türbereich befindet, und kann daher in Verbindung sowohl mit Türantrieben als auch mit Türschließern eingesetzt werden.

Die gebündelte Strahlung bedeutet, dass keine zum Teil als gefährlich angesehene Radarstrahlung verwendet wird. Die Verschwenkbarkeit des Sensorteils um eine Schwenkachse erlaubt es, den Sensor initial auf einen bestimmten Erfassungsbereich einzustellen. Aber auch im Betrieb kann das Sensorteil verstellt werden, wenn beispielsweise gesetzliche Normen dies erforderlich machen und/oder sich der Einsatzzweck des Näherungssensors ändert. Somit kann mit ein und demselben Näherungssensor eine Vielzahl an Anwendungsmöglichkeiten abgedeckt werden.

Weitere Merkmale und Vorteile der Erfindung ergeben sich aus der nachfolgenden Beschreibung bevorzugter Ausführungsformen.

Es zeigen:
- **Figur1:**: eine Näherungssensoranordnung gemäß eines ersten Beispiels,
- **Figur 2A:**: eine Näherungssensoranordnung gemäß eines zweiten Beispiels,
- **Figur 2B:**: eine Näherungssensoranordnung gemäß einer Ausführungsform der Erfindung,
- **Figur 3:**: eine Prinzipdarstellung der Funktionsweise des Näherungssensors gemäß Figuren 1 und 2,
- **Figur 4:**: einen Abdeckrahmen für einen der Näherungssensoren gemäß Figuren 1 und 2,
- **Figur 5:**: eine Näherungssensoranordnung gemäß eines dritten Beispiels,
- **Figur 6:**: eine Näherungssensoranordnung gemäß eines vierten Beispiels und
- **Figur 7:**: Verschwenkvorrichtungen gemäß verschiedenen Beispielen.

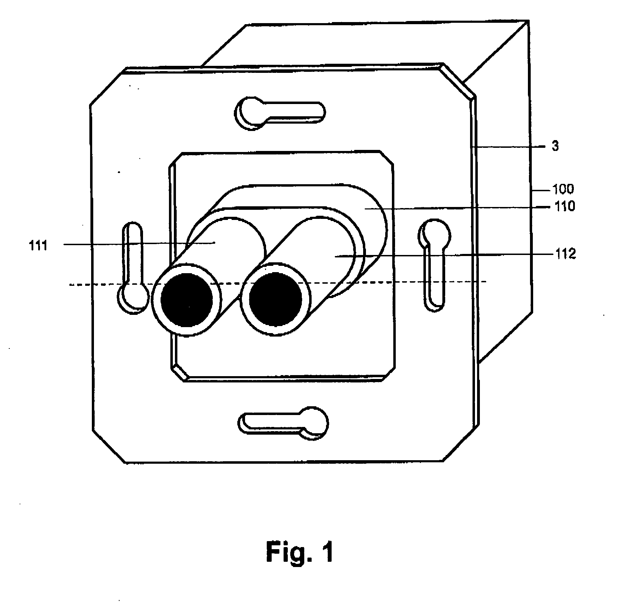

Figur 1 zeigt eine Näherungssensoranordnung gemäß eines ersten Beispiels.

Ein Näherungssensor 100 ist an einem Tragring 3 angebracht. Der Näherungssensor 100 umfasst hauptsächlich ein Sensorteil 110. Das Sensorteil 110 umfasst ein Sendeelement 111 sowie ein Empfangselement 112. Die Elemente 111, 112 sind im Wesentlichen rohrförmig ausgebildet. Das Sendeelement 111 strahlt in einem vorbestimmten Erfassungsbereich eine gebündelte Strahlung, die vorzugsweise ein Infrarot-Lichtstrahl ist.

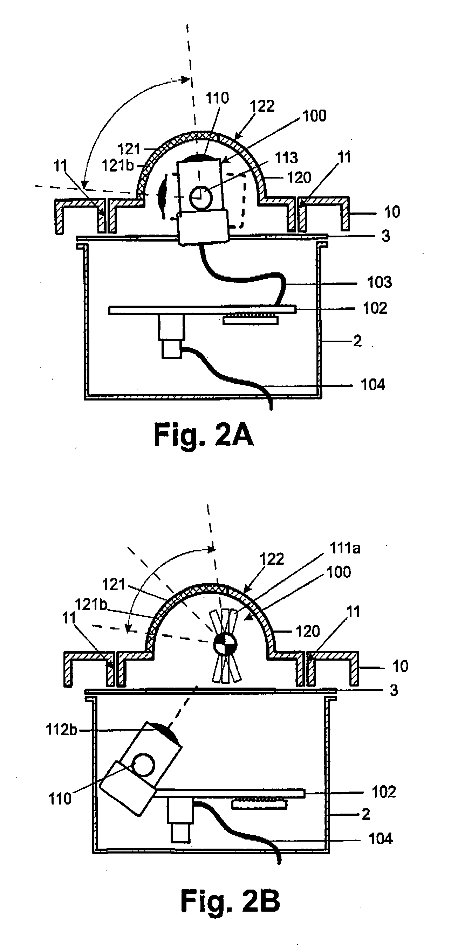

Figur 2A zeigt eine Näherungssensoranordnung gemäß eines zweiten Beispiels in einer Schnittansicht, eingesetzt in eine Unterputzdose 2. im Inneren der Unterputzdose 2 ist vorzugsweise einer Platine 102 angeordnet, die notwendige Ansteuerelektronik und gegebenenfalls Auswerteelektronik sowie Anschlüsse für Verbindungsleitungen 103 sowie für nach außen geführte Anschlussleitungen 104 aufweist. Das Sensorteil 110 ist in einer Halterung 101 frei rotierbar gelagert aufgenommen. Dadurch kann das Sensorteil 110 entlang der Kreislinie mit Doppelpfeil in Figur 2. Arotiert werden. Das Sensorteil 110 ist durch einen Hohlraum im Tragring 3 hindurch nach außen, d. h. nach oben in Figur 2A, geführt.

Das Sensorteil 110 ist von einer Abdeckung 120 bedeckt, die das Sensorteil 110 hauptsächlich vor Verschmutzung schützt. Die Abdeckung 120 bildet im Verschwenkbereich des Sensorteils 110 eine Ausbuchtung 122.

Im Emissionsbereich des Sensorteils 110 weist die Abdeckung 120 einen Durchtrittsabschnitt 121 auf. Der Emmissionsbereich ist der Bereich, innerhalb dessen die emittierte Strahlung das nicht näher dargestellte Sendeelement 111 verlässt. Der Durchtrittsabschnitt 121 ist mittels eines Abdeckteils 121 b nach außen hin abgedeckt, das für die Strahlung durchlässig ist, die vom nicht näher dargestellten Sendeelement 111 emittiert wird. Seitlich der Abdeckung 120 ist ein Abdeckrahmen 10 angeordnet. Der Abdeckrahmen 10 weist eine Ausnehmung 11 auf, in die die Abdeckung 120 eingesetzt ist.

Eine in Figur 2A dargestellte Schwenkachse 113 kann weiter nach oben verschoben werden. Dies hat den Vorteil, dass die Ausbuchtung sehr flach ausgeführt werden kann, was unter ästhetischen Gesichtspunkten günstig ist. Die Schwenkachse befindet sich vorzugsweise zwischen 0 und 15 mm außerhalb der Unterputzdose 2.

Figur 2B zeigt eine Näherungssensoranordnung gemäß einer Ausführungsform der Erfindung. Im Gegensatz zum Näherungssensor 100 gemäß Figur 2A ist das Sensorteil 110 in Bezug auf die Platine 102 ortsfest angeordnet. Die vom Sensorteil 110 emittierte Strahlung wird mittels eines Spiegels 111 a in Richtung Erfassungsbereich umgelenkt. Der Spiegel 111 a ist frei rotierbar angeordnet.

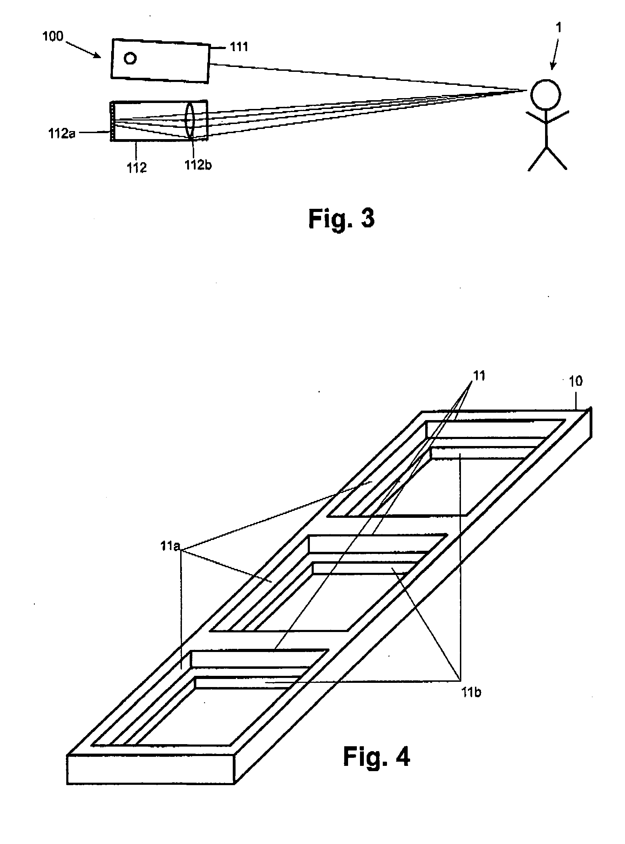

Figur 3 zeigt eine Prinzipdarstellung der Funktionsweise des Näherungssensors 100. Der vom Sendeelement 111 emittierte Strahl wird von einem Objekt 1, beispielsweise einer Person, in verschiedene Richtungen reflektiert. Verschiedene Richtungen sind mittels mehrerer, zum Empfangselement 112 gerichteter Linien angedeutet. Das Empfangselement 112 weist strahlungseingangsseitig vorzugsweise ein Objektiv 112b auf. Das Objektiv 112 dient dem Bündeln der einfallenden Reflexionsstrahlen. Damit ist es möglich, diese Reflexionsstrahlen zu fokussieren, sodass nur ein bestimmter Teil der lichtempfindlichen Elemente 112a von einfallenden Strahlen getroffen wird. Damit ist es mittels bekannter Triangulationsverfahren möglich, eine Entfernung des Objekts 1 zum Näherungssensor 100 zu ermitteln.

Aufgrund der kleinen Abmaße des Näherungssensors 100 ist es möglich, diesen in herkömmlichen Unterputzdosen zu integrieren bzw. zu installieren. Besonders vorteilhaft ist die Möglichkeit, den Näherungssensor 100 in mehrelementige Unterputzdoseninstallationen zu integrieren. Figur 4 zeigt einen Abdeckrahmen 10 beispielsweise für drei Standard-Unterputzinstallationen. Dazu weist der Abdeckrahmen 10 drei Ausnehmungen 11 auf. Jeder Ausnehmung 11 hat eine im gezeigten Beispiel quadratische Querschnittsform mit einer Kantenlänge von vorzugsweise 55 mm. Unterhalb eines Einsatzabschnitts 11 a schließt sich ein Aufsatzabschnitt 11 b an, dessen Innenabmessungen zumindest teilweise geringer sind als entsprechende Innenabmessungen des Einsetzabschnitts 11a.

Bei einer Unterputzmontage wird der Näherungssensor 100 am Tragring 3 befestigt. Der Tragring 3 wird auf der Unterputzdose 2 befestigt. Daraufhin wird der Abdeckrahmen 10 auf den Tragring 3 aufgesetzt, und danach wird die Abdeckung 120 auf den Abdeckrahmen 10 und den Tragring 3 aufgesetzt und zumindest am Tragring 3 befestigt.

Die Näherungssensoranordnungen gemäß Figuren 2A und 2B ermöglichen, dass die emittierte Strahlung im Extremfall parallel zu einer Längserstreckung des Tragrings 3, d. h. parallel zu einer nicht dargestellten Wand, das Sendeelement 111 verlässt. Dies ist insbesondere bei Türanlagen von Vorteil, bei denen es erforderlich sein kann, einen Bereich direkt vor einem Türflügel zu überwachen.

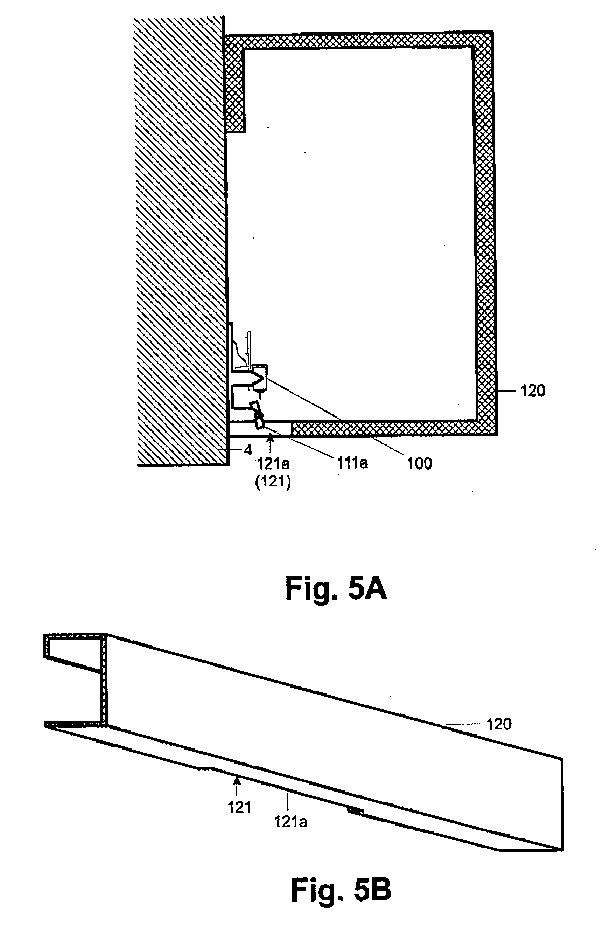

Der Näherungssensor 100 kann auch innerhalb einer Abdeckung 120 angeordnet sein, die an einem Sturz 4 einer nicht dargestellten Tür angeordnet sein kann. Wie Figur 5A zeigt, weist solch eine Abdeckung 120 als Durchtrittsabschnitt 121 eine Ausnehmung 121a auf. Im gezeigten Beispiel ist ein Näherungssensor 100 gezeigt, der über einen Spiegel 111 a verfügt. Es kann jedoch auch ein Näherungssensor 100 eingesetzt werden, bei dem das Sensorteil 110 verschwenkbar ist. Wie in Figur 5B gezeigt, erstreckt sich die Ausnehmung 121a in Längsrichtung der Abdeckung 120 nur über einen Teilabschnitt der Abdeckung 120. Sie kann sich allerdings auch über die gesamte Länge der Abdeckung 120 erstrecken.

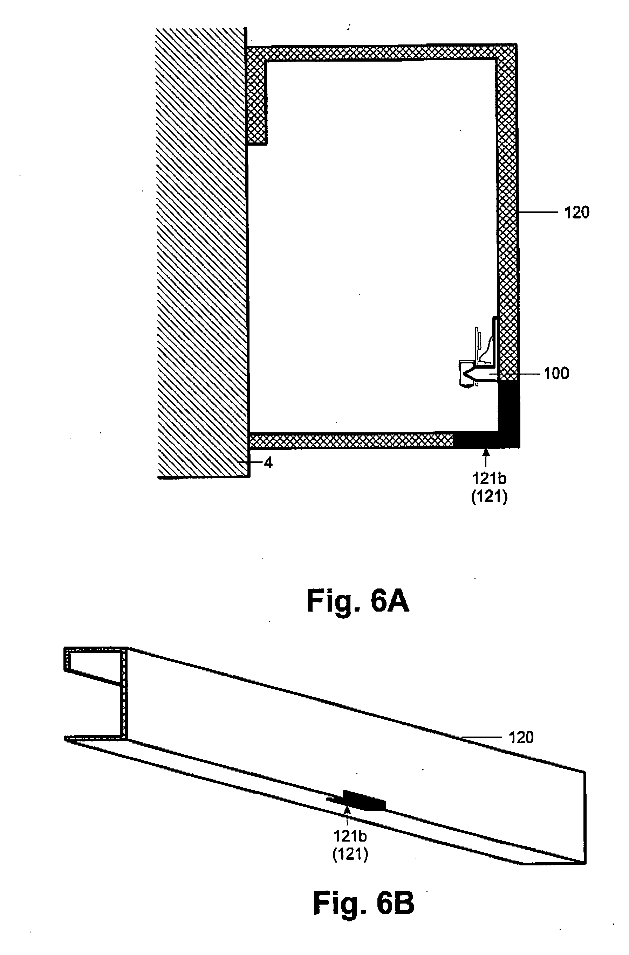

Figur 6 zeigt eine andere Anordnung des Näherungssensors 100 in einer Abdeckung 120. im Gegensatz zum vorigen Beispiel weist die Abdeckung 120 einen Durchtrittsabschnitt 121 in Form eines Abdeckteils 121b auf. Aus ästhetischen Gründen ist das Abdeckteil 121b. getönt. Die Tönung ist allerdings derart, dass vom Näherungssensor emittierte Strahlung das Abdeckteil 121b in einem Maße durchdringen kann, dass die Funktionsweise des Näherungssensors 100 gewährleistet bleibt. Da der Durchtrittsabschnitt 121 in Figur 6 nach unten weist und der Näherungssensor 100 vollständig in der Abdeckung 120 aufgenommen ist, kann das Abdeckteil 121 b auch mittels einer Durchgangsöffnung gebildet sein.

Aus optischen Gründen kann das Abdeckteil 121 b auch über die gesamte Länge der Abdeckung 120 ausgebildet sein.

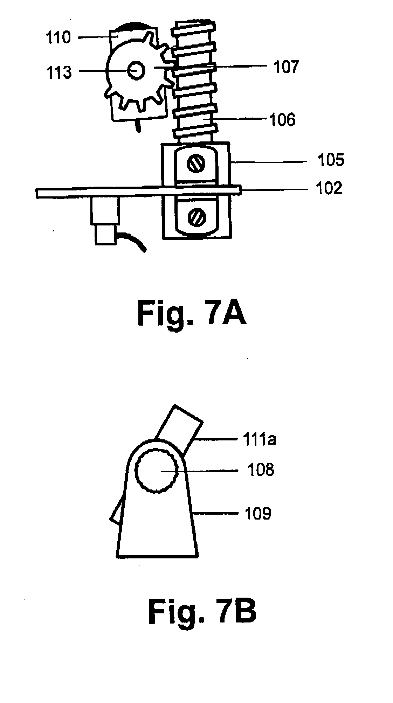

Gemäß eines in Figur 7A gezeigten Beispiels weist das Sensorteil 110 ein Zahnsegment 107 auf, das um die Schwenkachse 113 des Sensorteils 110 frei rotierbar und in Bezug auf das Sensorteil 110 ortsfest angeordnet ist. D. h. ein Rotieren des Zahnsegments 107 führt zu einer Verschwenkung des Sensorteils 110. Das Zahnsegment 107 kämmt mittels seiner Verzahnung vorzugsweise mit einem Schneckenrad 106. Das Schneckenrad 106 ist mit einer nicht sichtbaren Abtriebswelle eines Elektromotors 105 wirkverbunden. Anstelle des Schneckenrads 106 kann jedes andere, eine Verzahnung aufweisende Getriebeteil verwendet werden. Derartige Getriebeteile sind beispielsweise Stirnräder, Kegelräder oder auch eine Zahnstange. Der Elektromotor 105 ist im gezeigten Beispiel mittels nicht näher bezeichneter Halterungen an der Platine 102 befestigt.

Alternativ ist die Schwenkachse 113 mittels eines frei rotierbar gelagerten Teils gebildet, das mit dem Sensorteil 110 bzw. dem Spiegel 111a drehfest angeordnet ist. Das Teil ist in einem Abschnitt aus einem magnetisierbaren Material gebildet. Der Abschnitt ist vorzugsweise im Querschnitt kreisrund. An einer Umfangsfläche sind im Abstand Wicklungen aus Elektrodrähten angeordnet. Der Abschnitt bildet somit einen Anker bzw. Läufer eines Elektromotors, und die Elektrodrähte bilden den Stator dieses Elektromotors.

Die motorische Verstellung ist insbesondere vorteilhaft bei schwer oder nicht zugänglichen Stellen, an denen der Näherungssensor angeordnet ist.

Verfügt der Näherungssensor 100 zusätzlich über einen Steuereingang, der mittels Kabel oder Funk mit einer Einstellvorrichtung, wie beispielsweise einem PDA, gekoppelt werden kann, kann die Einstellung des Näherungssensors 100 in einiger Entfernung zu diesem beispielsweise auch über eine zentrale Steuerung eingestellt werden. Dazu verfügt der Näherungssensor 100 vorzugsweise über eine Busschnittstelle, die mit einem Bussystem, wie beispielsweise einem LON-Bus, gekoppelt ist.

Im Fall einer Funkkopplung mit dem Näherungssensor 100 kann dieser auch in Ganzglas-Anlagen integriert werden, da keine Kabel verlegt werden müssen. Die Stromversorgung des Näherungssensors muss in diesem Fall autark erfolgen, beispielsweise über einen Akku oder eine Solarzellenvorrichtung.

Zum manuellen Arretieren des verschwenkbaren Sensorteils 110 und/oder Spiegels 111a ist vorgesehen, dass zumindest ein Lagerzapfen oder eine Lagerachse der Verschwenklagerung unter Reibung in einer Aufnahme rotierbar gelagert ist. Die Arretierung erfolgt somit mittels Kraftschlusses von Lagerzapfen bzw. Lagerachse und Lagerung.

Zusätzlich oder alternativ kann mittels des Lagerzapfens oder der Lagerachse mit der zugehörigen Lagerung eine formschlüssige Arretierung realisiert sein. Wie in Figur 7B gezeigt, weist ein Lagerzapfen 108 für in diesem Fall den Spiegel 111a im Querschnitt eine unrunde Außenkontur auf. Die Lagerung weist eine zu dieser Außenkontur im Wesentlichen komplementär ausgebildete Innenkontur auf und ist in einer Spiegelhalterung 109 ausgebildet bzw. angeordnet. Damit ergeben sich definierte Rast- bzw. Arretierungsstellen für den Spiegel 111a.

Bei Einsatz der vorbeschriebenen Näherungssensoranordnungen in einer Anlage bzw. einem System, wie beispielsweise einer Türanlage, ist zumindest ein Näherungssensor 100 vorgesehen. Der Näherungssensor 100 weist zumindest einen Signalausgang auf. Mit dem Signalausgang ist vorzugsweise eine Auswerteschaltung vorzugsweise als Teil des Näherungssensors 100 gekoppelt.

Die Auswerteschaltung ermittelt zunächst, welche der lichtempfindlichen Elemente 112a des Näherungssensors 100 ein Maximum an Strahlung empfangen haben, und ob das Maximum einer von einem Objekt 1 reflektierten Strahlung entspricht. Dies erfolgt vorzugsweise über die Strahlungsintensitätsverteilung über die lichtempfindlichen Elemente 112a.

Hat die Auswerteschaltung das Vorhandensein eines solchen Objekts 1 ermittelt, ermittelt sie die Entfernung des Objekts 1. Da die emittierte Strahlung gebündelt, d. h. strahlenförmig ist, kann die Entfernung einfach mittels Triangulation ermittelt werden.

Schließlich kann die Auswerteschaltung, falls erforderlich, ermitteln, ob die ermittelte Entfernung größer bzw. kleiner als eine vorbestimmte Referenz-Entfernung ist oder nicht.

Vorzugsweise ist die Auswerteschaltung signalausgangsseitig mit einer Aktivierungsschaltung gekoppelt. Diese kann separat ausgebildet sein oder ein Stellelement, wie beispielsweise ein Antriebsmotor eines Türantriebs, selbst sein. Bei erkanntem Vorhandensein eines Objekts und ggf. Unterschreiten und/oder Überschreiten der Referenz-Entfernung gibt die Auswerteschaltung ein Aktivierungssignal an die gekoppelte(n) Aktivierungsschaltung(en) aus.

Vorzugsweise können automatische Türanlagen, d. h. mit Antrieben versehene Türanlagen, mit solch einem Näherungssensor ausgestattet werden. Allerdings ist der Näherungssensor auch für Türanlagen geeignet, bei denen Feststellvorrichtungen mit oder ohne Türschließern bzw. Türantrieben eingesetzt sind. In dem Fall wird der Näherungssensor verwendet, um zu ermitteln, wann der überwachte Bereich frei ist. Beispielsweise in Altenheimen kann es erwünscht sein, eine Tür solange festzustellen, solange sich Personen im Gefahrenbereich einer Tür befinden. Erst wenn dieser Gefahrenbereich geräumt ist, kann die Türfeststellung gelöst werden.

Die Erfindung ist nicht auf die oben beschriebene Ausführungsform beschränkt.

Zudem kann das Sendeelement 111 eingerichtet sein, mehrere Strahlenbündel zu emittieren. Dies kann beispielsweise mittels eines Strahlenteilers beispielsweise in Form eines Glasprismas erfolgen, das im optischen Pfad der vom Sendeelement 111 emittierten Strahlung angeordnet ist.

Dadurch ist es möglich, einen räumlichen Bereich oder verschiedene, voneinander getrennte Gefahrenbereiche zu überwachen.

Dafür können die lichtempfindlichen Elemente 112a in separate Gruppen aufgeteilt jeweils in einer Matrixform angeordnet sein. Im einfachsten Fall sind die lichtempfindlichen Elemente 112a somit jeweils in einer Linie angeordnet.

Die Umlenkoptik wurde in Verbindung mit einem Spiegel 111a beschrieben. Es ist allerdings jede andere Art von Umlenkoptik möglich. Beispielsweise sind Glaskörper einsetzbar, die so angeordnet sind, dass die Strahlung des Sendeelements 111 an der Oberfläche des Glaskörpers total reflektiert wird.

Als Sendeelement 111 sind vorzugsweise Leuchtdioden, Laser oder Laserdioden verwendet.

Die Schwenkachse des Sensorteils 110 bzw. Spiegels 111a verläuft bei Unterputzmontage vorzugsweise vertikal, d. h. entlang einer senkrechten Verbindungslinie zwischen einer Decke und einem Boden eines Raums. D. h. eine Verschwenkebene des Sensorteils 110 bzw. Spiegels 111 a verläuft horizontal oder parallel zu der Decke bzw. dem Boden.

Im Fall beispielsweise von Türen kann der maximale Verschwenkbereich so gestaltet sein, das er in Bezug auf die Anbringfläche, wie beispielsweise eine Wand, nicht 180° umfasst. Beispielsweise bei Unterputzmontage in der Wand seitlich einer Tür oder einer Montage in einem feststehenden Ganzglasflügel ist lediglich die Seite in Bezug auf den Näherungssensor 100 von Interesse, auf der sich die zu überwachende Tür befindet. D. h. das Sensorteil 110 bzw. der Spiegel 111a wird in der Regel immer in Richtung Tür gerichtet sein. In dem Fall kann der Näherungssensor 100 so ausgebildet sein, dass das Sensorteil 110 bzw. der Spiegel 111 a maximal um 90° verschwenkt werden muss, was Platzvorteile hinsichtlich der zu verschwenkenden Teile bringt.

Für den Fall kann der Näherungssensor 100 sowohl rechts als auch links einer Tür eingesetzt werden, er muss vor dem Einsetzen lediglich um 180° rotiert werden. Der Durchtrittsabschnitt 121 ist dann lediglich auf einer Seite der Ausbuchtung 122 auszubilden, kann aber auch für den gesamten 180°-Verschwenkbereich ausgebildet sein.

Zusätzlich kann eine Aufputzmontage vorgesehen sein, indem der Näherungssensor 100 ferner eine Aufputzdose aufweist, die die Funktion der Unterputzdose 2 übernimmt. Alternativ ist die Abdeckung 120 zusätzlich als Aufputz-Montageteil ausgebildet.

Vorzugsweise ist der Erfassungsbereich des Näherungssensors 100 nicht nur mittels der Richtung des/r emittierten Strahls/en einstellbar sondern auch mittels einer maximalen Entfernungseinstellung vorzugsweise bis zu 150 cm. Dies kann erfolgen, indem die Auswerteschaltung angewiesen wird, zu untersuchende Gruppierungen der lichtempfindlichen Elemente 112a zu ändern bzw. auszublenden.

Das vorbeschriebene Zahnsegment 107 kann durch ein vollständiges Zahnrad, beispielsweise ein Stirnrad, ausgebildet sein. Alternativ kann die Verzahnung auch als Zahnkranz als einstückiger Bestandteil des zu verschwenkenden Teils auf dessen Umfangsfläche ausgebildet sein.

Im Ergebnis ist der Näherungssensor flexibel einsetzbar und an verschiedene Einsatzbedingungen einfach anpassbar.

### Bezugszeichenliste

- 1: Objekt
- 2: Unterputzdose
- 3: Tragring
- 4: Sturz

- 10: Abdeckrahmen
- 11: Ausnehmung
- 11a: Einsetzabschnitt
- 11b: Aufsetzabschnitt

- 100: Näherungssensor
- 101: Halterung
- 102: Platine
- 103: Verbindungsleitung
- 104: Anschlussleitung
- 105: Elektromotor
- 106: Schneckenrad
- 107: Zahnsegment
- 108: Lagerzapfen
- 109: Spiegelhalterung

- 110: Sensorteil
- 111: Sendeelement
- 111a: Spiegel
- 112: Empfangselement
- 112a: lichtempfindliches Element
- 112b: Objektiv
- 113: Schwenkachse

- 120: Abdeckung
- 121: Durchtrittsabschnitt
- 121a: Ausnehmung
- 121 b: Abdeckteil
- 122: Ausbuchtung

## Patentansprüche

1. System mit einer Unterputzdose (2) und einem Näherungssensor (100), wobei der Näherungssensor (100) aufweist:
• zumindest ein Sensorteil (110), umfassend
- ein Sendeelement (111), eingerichtet, eine gebündelte Strahlung in einen vorbestimmten Erfassungsbereich zu emittieren, und
- ein Empfangselement (112), das derart angeordnet ist, dass es von dem ersten Sendeelement (111) emittierte und von einem in dem vorbestimmten Erfassungsbereich befindlichen Objekt (1) reflektierte Strahlung empfängt, und
• eine Umlenkoptik (111a), die in einem optischen Pfad der emittierten Strahlung zwischen dem Sendeteil und dem vorbestimmten Erfassungsbereich angeordnet und schwenkbar gelagert, in verschiedenen Stellungen arretierbar und in einer der verschiedenen Stellungen arretiert ist,
wobei im Inneren der Unterputzdose (2) eine Platine (102) angeordnet ist, wobei das Sensorteil (110) in Bezug auf die Platine (102) ortsfest angeordnet ist und wobei das Sensorteil (110) im Innenraum der Unterputzdose (2) fest montiert und versenkt ist.

2. System nach Anspruch 1, wobei das Empfangselement (112)
• mehrere lichtempfindliche Elemente (112a), die gemäß einer vorbestimmten Matrix angeordnet sind, und
• ein zwischen dem Objekt (1) und den lichtempfindlichen Elementen (112a) derart angeordnetes Objektiv (112b) aufweist, dass von dem Objekt (1) reflektierte Strahlung durch das Objektiv (112b) hindurch tritt und mittels des Objektivs (112b) gebündelt wird.

3. System gemäß Anspruch 1, wobei die Umlenkoptik mittels eines frei rotierbar gelagerten Spiegels (111 a) gebildet ist.

4. System gemäß einem der vorhergehenden Ansprüche, wobei es sich bei der emittierten Strahlung um Licht im Infrarot-Bereich handelt.

5. System gemäß einem der vorhergehenden Ansprüche, wobei das Sendeelement (111) ein Laser, eine Leuchtdiode oder eine Laserdiode ist.

6. System gemäß einem der vorhergehenden Ansprüche, ferner aufweisend eine Abdeckung (120), die
• alle anderen Teile des Näherungssensors (100) im Montagezustand in eine Richtung abdeckt und
• zumindest einen Durchtrittsabschnitt (121) aufweist, der für die emittierte Strahlung durchlässig ist.

7. System gemäß Anspruch 6, wobei der Durchtrittsabschnitt (121) mittels einer Ausnehmung (121a) oder Durchgangsöffnung in der Abdeckung (120) gebildet ist.

8. Anlage, aufweisend
• zumindest ein System gemäß einem der vorhergehenden Ansprüche,
• eine mit einem Ausgang des Empfangselements (112) des zumindest einen Sensorteils (110) gekoppelte Auswerteschaltung und
• einen eingangsseitig mit einem Ausgang der Auswerteschaltung gekoppelte Aktivierungsschaltung,
- wobei die Auswerteschaltung eingerichtet ist, folgende Schritte auszuführen:
• Ermittlung lichtempfindlicher Elemente (112a), an denen ein Maximum einer am Empfangselement (112) ankommenden Strahlung vorliegt,
• Ermitteln eines Vorhandenseins eines Objekts (1) aufgrund der ermittelten Elemente (112a) und
• bei ermitteltem Vorhandensein, Ausgeben eines Aktivierungssignals an die Aktivierungsschaltung.

9. Anlage gemäß Anspruch 8, wobei
- die Auswerteschaltung ferner eingerichtet ist, folgende Schritte auszuführen:
• Ermitteln einer Entfernung eines die Strahlung reflektierenden Objekts (1) aufgrund der ermittelten Elemente (112a),
• Erkennen eines Unterschreitens und/oder Überschreitens einer vorbestimmten Entfernung und
• bei erkanntem Unterschreiten und/oder Überschreiten der vorbestimmten Entfernung, Ausgeben eines Aktivierungssignals an die Aktivierungsschaltung.

10. Anlage gemäß Anspruch 8 oder 9, ferner aufweisend einen Türantrieb und/oder eine Tür-Feststellvorrichtung, der bzw. die eingangsseitig mit einem Aktivierungsausgang der Aktivierungsschaltung gekoppelt ist.

## Claims

1. A system with a flush-mounted socket (2) and a proximity sensor (100), wherein the proximity sensor (100) includes:
• at least one sensor component (110), comprising
- a transmission element (111), which is adapted to emit a focused radiation into a predetermined detection area, and
- a reception element (112), which is disposed in such a way that it receives radiation which was emitted by the first transmission element (111) and reflected by an object (1), which is located in the predetermined detection area, and
• deflection optics (111 a), which are disposed on an optical path of the emitted radiation between the transmission component and the predetermined detection area and are supported to be pivotable, arrestable in different positions, and are arrested in one of the various positions,
wherein a printed circuit board (102) is disposed inside the flush-mounted socket (2), wherein the sensor component (110) is stationarily disposed with regard to the printed circuit board (102) and wherein the sensor component (110) is tightly mounted in the inside of the flush-mounted socket (2) and is countersunk.

2. The system according to claim 1, wherein the reception element (112) includes
• several light-sensitive elements (112a), which are arranged according to a predetermined matrix, and
• a lens system (112b) disposed between the object (1) and the light-sensitive elements (112a) in such a way that the radiation, which is reflected by the object (1), passes through the lens system (112b) and is focused by means of the lens system (112b).

3. The system according to claim 1, wherein the deflection optics are formed by means of a mirror (111a) which is supported to be freely rotatable.

4. The system according to any of the preceding claims, wherein the emitted radiation consists of light in the infrared spectrum.

5. The system according to any of the preceding claims, wherein the transmission element (111) consists of a laser, of a light emitting diode or of a laser diode.

6. The system according to any of the preceding claims, furthermore including a cover (120), which
• covers all other components of the proximity sensor (100) in the mounted condition in one direction, and
• includes at least one passage section (121), which is transmissive for the emitted radiation.

7. The system according to claim 6, wherein the passage section (121) is formed by means of a recess (121a) or a through-opening in the cover (120).

8. An installation, including
• at least one system according to any of the preceding claims,
• an evaluation circuit, which is coupled to an output of the reception element (112) of the at least one sensor component (110), and
• an activation circuit, which, on the input side, is coupled to an output of the evaluation circuit,
- wherein the evaluation circuit is adapted to perform the following steps:
• detecting light-sensitive elements (112a), at which a maximum radiation arriving at the reception element (112) is present,
• detecting the presence of an object (1) based on the detected elements (112a), and
• in case of detected presence, emitting an activation signal to the activation circuit.

9. The installation according to claim 8, wherein
• the evaluation circuit is furthermore adapted to perform the following steps:
- detecting, based on the detected elements (112a), a distance of an object (1) reflecting the radiation,
• recognizing a falling below and/or exceeding of a predetermined distance, and
• in the event of recognized falling below and/or exceeding the predetermined distance, emitting an activation signal to the activation circuit.

10. The installation according to claim 8 or 9, furthermore including a door drive and/or a door hold-open device, which, on the input side, are coupled to an activation output of the activation circuit.

## Revendications

1. Système avec un boîtier d'encastrement (2) et avec un détecteur de proximité (100), le détecteur de proximité (100) comprenant :
• au moins un composant détecteur (110), comportant
- un élément de transmission (111), qui est adapté à émettre un rayonnement focalisé dans une région de détection prédéterminée, et
- un élément de réception (112), qui est agencé de façon à recevoir le rayonnement qui est émis par le premier élément de transmission (111) et réfléchi par un objet (1) qui se trouve dans la région de détection prédéterminée, et
• un système optique de renvoi (111a), lequel est agencé dans une trajectoire optique du rayonnement émis entre le composant de transmission et la région de détection prédéterminée et est supporté de façon pivotable, peut être arrêté dans des positions différentes et est arrêté dans une des différentes positions,
une platine (102) étant agencée à l'intérieur du boîtier d'encastrement (2), le composant détecteur (110) étant agencé de façon stationnaire par rapport à la platine (102) et le composant détecteur (110) étant installé de façon fixe et étant noyé dans le compartiment intérieur du boîtier d'encastrement (2).

2. Système selon la revendication 1, dans lequel l'élément de réception (112)
• comprend plusieurs éléments photosensibles (112a), qui sont agencés selon une matrice prédéterminée, et
• comprend un objectif (112b) qui est agencé entre l'objet (1) et les éléments photosensibles (112a) de telle façon que le rayonnement réfléchi par l'objet (1) passe à travers l'objectif (112) et est focalisé par l'intermédiaire de l'objectif (112b).

3. Système selon la revendication 1, dans lequel le système optique de renvoi est aménagé au moyen d'un miroir (111a) qui est supporté de façon à tourner librement.

4. Système selon l'une des revendications précédentes, dans lequel le rayonnement émis consiste en lumière dans le spectre infrarouge.

5. Système selon l'une des revendications précédentes, dans lequel l'élément de transmission (111) consiste en un laser, en une diode électroluminescente ou en une diode laser.

6. Système selon l'une des revendications précédentes, comprenant en plus un recouvrement (120), lequel
• couvre tous les autres composants du détecteur de proximité (100) en condition d'installation en une direction, et
• comprend au moins une section de passage (121), laquelle est transmissible au rayonnement émis.

7. Système selon la revendication 6, dans lequel la section de passage (121) est aménagée par l'intermédiaire d'un décrochement (121 a) ou d'une ouverture de passage dans le recouvrement (120).

8. Installation, comprenant
• au moins un système selon l'une des revendications précédentes,
• un circuit d'évaluation couplé à une sortie de l'élément de réception (112) dudit au moins un composant détecteur (110), et
• un circuit d'activation couplé du côté entrée à une sortie du circuit d'évaluation,
- le circuit d'évaluation étant adapté à exécuter les étapes suivantes :
• détection des éléments photosensibles (112a) auxquels un maximum d'un rayonnement arrivant à l'élément de réception (112) est présent,
• détection de la présence d'un objet (1) sur la base des éléments détectés (112a), et
• en cas de présence détectée, émission d'un signal d'activation au circuit d'activation.

9. Installation selon la revendication 8, dans laquelle
• le circuit d'évaluation est adapté en plus à exécuter les étapes suivantes :
- détection, sur la base des éléments détectés (112a), d'une distance d'un objet (1) réfléchissant le rayonnement,
• reconnaissance d'un dépassement négatif et/ou d'un dépassement d'une distance prédéterminée, et
• en cas de reconnaissance d'un dépassement négatif et/ou d'un dépassement d'une distance prédéterminée, émission d'un signal d'activation au circuit d'activation.

10. Installation selon la revendication 8 ou 9, comprenant en plus un entraînement de porte et/ou un système de maintien de porte ouverte, lequel est couplé ou lesquels sont couplés à une sortie d'activation du circuit d'activation.
